(19) Europäisches Patentamt
European Patent Office
Office européen des brevets

(11) **EP 2 479 766 A2**

(12) **EUROPEAN PATENT APPLICATION**

(43) Date of publication:
**25.07.2012 Bulletin 2012/30**

(51) Int Cl.:
**H01G 9/20** *(2006.01)*  **H01L 51/00** *(2006.01)*

(21) Application number: **12151695.9**

(22) Date of filing: **19.01.2012**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **21.01.2011 KR 20110006505**

(71) Applicant: **Samsung SDI Co., Ltd.**
**Gyeonggi-do (KR)**

(72) Inventors:
• **Shin, Byong-Cheol**
  **Gyeonggi-do (KR)**
• **Lee, Ji-Won**
  **Gyeonggi-do (KR)**
• **Kim, Chang-Wook**
  **Gyeonggi-do (KR)**
• **Park, Do-Young**
  **Gyeonggi-do (KR)**

(74) Representative: **Mounteney, Simon James**
  **90 Long Acre**
  **London WC2E 9RA (GB)**

(54) **Dye sensitized solar cell, and method of manufacturing the same**

(57) A dye-sensitized solar cell including a first electrode, a negative photoelectrode on the first electrode, a light scattering layer on a surface of the negative photoelectrode, a second electrode facing the first electrode with the negative photoelectrode and the light scattering layer therebetween, and an electrolyte between the first electrode and the second electrode. The light scattering layer includes a titanium dioxide nano wire and a titanium dioxide nano particle.

FIG. 1

**Description**

**BACKGROUND**

**1. Field**

The present invention relates to a dye-sensitized solar cell and a method of manufacturing a dye-sensitized solar cell.

**2. Description of Related Art**

An example dye-sensitized solar cell includes a negative photoelectrode to which a photosensitive dye is adsorbed, an electrolyte containing oxidation/reduction ion pairs, and a counter electrode including a platinum (Pt) catalyst. The negative photoelectrode typically includes metal oxide particles having a wide band gap.

In dye-sensitized solar cells, when solar light is incident thereon, a photosensitive dye absorbs light and enters an excitation state and then transfers electrons into a metal oxide conduction band. Then, the conducted electrons flow to an external circuit to transfer electric energy thereto. At this point, the electrons, whose energy is reduced by the amount of transferred energy, flow to a counter electrode.

Then, the photosensitive dye receives (from an electrolyte) the same number of electrons as those emitted to the metal oxide to return to a ground state. In this regard, the electrolyte transfers electrons from the counter electrode to the photosensitive dye through oxidization and reduction of the oxidation / reduction ion pairs.

In order to increase energy conversion efficiency, a specific surface area of a negative photoelectrode should be increased to thus increase the amount of dye adsorbed. This will increase the efficiency of generating photoelectrons, and electrons transferred from the photosensitive dye to the metal oxide should be easily moved to an electrode. In addition, loss of the solar light transmitted through the negative photoelectrode should be reduced.

**SUMMARY**

Aspects of the present invention are directed toward a dye-sensitized solar cell having high efficiency, and a method of manufacturing the dye-sensitized solar cell. Additional aspects will be set forth in part in the description that follows and, in part, will be apparent from the description, or may be learned by practice of the presented embodiments.

In one aspect of the present invention, a dye-sensitized solar cell is provided. The dye-sensitized solar cell includes a first electrode, a negative photoelectrode on the first electrode, a light scattering layer on the negative photoelectrode, a second electrode facing the first electrode with the negative photoelectrode and the light scattering layer therebetween, and an electrolyte between the first electrode and the second electrode. The light scattering layer includes a titanium dioxide nano wire and a titanium dioxide nano particle.

The titanium dioxide nano particle may be attached to at least one surface of the titanium dioxide nano wire to form a composite with the titanium dioxide nano wire.

A thickness of the light scattering layer may be from about 1 $\mu$m to about 5 $\mu$m.

A mean diameter of the titanium dioxide nano wire may be from about 10 nm to about 100 nm.

A mean diameter of the titanium dioxide nano particle may be from about 10 nm to about 90 nm.

The negative photoelectrode may include a titanium dioxide nano particle. A ratio of a diameter of the titanium dioxide nano wire and a diameter of the titanium dioxide nano particle included in the negative photoelectrode may be from about 1:1 to about 10:1.

In another aspect of the present invention, a method of manufacturing a dye-sensitized solar cell is provided. The method includes preparing an oxide semiconductor layer and forming a light scattering layer on the oxide semiconductor layer. The forming of the light scattering layer includes preparing a precursor solution, electro-spinning the precursor solution onto the oxide semiconductor, and heat-treating the precursor solution. The precursor solution includes a titanium dioxide precursor, titanium dioxide nano particles, a binder, and solvent.

The titanium dioxide precursor may include titanium isopropoxide, titanium ethoxide, titanium chloride, or titanium methoxide.

A mean diameter of the titanium dioxide nano particles may be from about 10 nm to about 90 nm.

An amount of the titanium dioxide nano particles may be from about 5 wt% to about 20 wt% based on a total weight of the precursor solution.

At least some of the above and other features of the invention are set out in the claims.

An amount of the titanium dioxide precursor in the precursor solution may be from about 10 parts by weight to about 150 parts by weight based on 100 parts by weight of the titanium dioxide nano particles.

An amount of the binder in the precursor solution may be from about 20 parts by weight to about 40 parts by weight based on 100 parts by weight of the titanium dioxide nano particles.

The electro-spinning may be performed for from about 10 minutes to about 30 minutes at a voltage in a range from about 5 kV to about 10 kV and at a rate in a range from about 10 $\mu\ell$/minute to about 15 $\mu\ell$/minute.

The heat-treating may be performed at a temperature in a range from about 400°C to about 550°C.

## BRIEF DESCRIPTION OF THE DRAWINGS

The above and/or other aspects of the invention will become apparent and more readily appreciated from the following description of embodiments, taken in conjunction with the accompanying drawings of which:

FIG. 1 is a cross-sectional view of a dye-sensitized solar cell according to an embodiment of the present invention;

FIG. 2A is a scanning electron microscope (SEM) image of a complex of titanium dioxide nano particles and titanium dioxide nano wires, prepared in Example 1; and

FIG. 2B is an enlarged image of FIG. 2A.

## DETAILED DESCRIPTION

Reference will now be made in detail to certain embodiments of the present invention, examples of which are illustrated in the accompanying drawings, wherein like reference numerals refer to like elements throughout. In this regard, the presented embodiments may have different forms in other embodiments and should not be construed as being limited to the descriptions set forth herein. Accordingly, the embodiments are merely described below, by referring to the figures, to explain aspects of the present invention. Hereinafter, a dye-sensitized solar cell, and a method of manufacturing the dye-sensitized solar cell, will be described with regard to embodiments of the invention with reference to the attached drawings.

A dye-sensitized solar cell according to an embodiment of the present invention includes a first electrode, a negative photoelectrode disposed on a surface of the first electrode, a light scattering layer disposed on a surface of the negative photoelectrode, a second electrode disposed to face the first electrode with the negative photoelectrode and the light scattering layer therebetween, and an electrolyte disposed between the first electrode and the second electrode. The light scattering layer includes titanium dioxide nano wires and titanium dioxide nano particles. The negative photoelectrode may include an oxide semiconductor layer on which the light scattering layer is formed.

In the dye-sensitized solar cell including the light scattering layer, the amount of solar light that is absorbed into the negative photoelectrode may be increased by the light scattering layer. This is because light transmitted through the first electrode and the negative electrode is scattered by the light scattering layer (including the titanium dioxide nano wires and the titanium dioxide nano particles). Accordingly, the light scattering layer reflects the scattered light on the negative photoelectrode. In addition, the efficiency of generating photoelectrons may be increased by a dye adsorbed to the titanium dioxide nano particles included in the light scattering layer. Further, a path for transferring electrons may be ensured by titanium dioxide nano wires included in the light scattering layer to thus reduce loss of photoelectrons due to electron recombination. As a result, incident-photon-to-current efficiency (IPCE) of the dye-sensitized solar cell may be increased.

In the dye-sensitized solar cell, the titanium dioxide nano particles may be attached to at least one surface of the titanium dioxide nano wires to form a composite with the titanium dioxide nano wires. When the complex is formed, photoelectrons formed in the titanium dioxide nano particles may be easily transferred to the titanium dioxide nano wires.

In the dye-sensitized solar cell, a thickness of the light scattering layer may be from about 1 micrometer ($\mu$m) to about 5 $\mu$m (or from 1 $\mu$m to 5 $\mu$m). For example, the thickness of the light scattering layer may be from about 2 $\mu$m to about 5 $\mu$m (or from 2$\mu$m to 5 $\mu$m). For another example, the thickness of the light scattering layer may be from about 2 $\mu$m to about 4 $\mu$m (or from 2$\mu$m to 4 $\mu$m). In one embodiment, when the thickness of the light scattering layer is within the range described above, solar light is increasingly scattered. On the other hand, in another embodiment, when the light scattering layer is excessively thick, light transmittance is reduced. In yet another embodiment, when the light scattering layer is excessively thin, light scattering is reduced. In addition, in still yet another embodiment, when the light scattering layer is excessively thick or thin, an adhesive force between the light scattering layer and the negative photoelectrode is reduced.

A diameter (for example, a mean diameter) of the titanium dioxide nano wires may be from about 10 nanometers (nm) to about 100 nm (or from 10 nm to 100 nm). In one embodiment, when the mean diameter is within the range described above, scattering of solar light is increased. On the other hand, in another embodiment, when the diameter of the titanium dioxide nano wires is excessively small, light scattering is reduced. In yet another embodiment, when the diameter of the titanium dioxide nano wires is excessively large, light transmittance is reduced.

A diameter (for example, a mean diameter) of the titanium dioxide nano particles may be from about 10 nm to about 90 nm (or from 10 nm to 90 nm). In one embodiment, when the mean diameter is within the range described above, a surface area of the titanium dioxide nano particles is increased, and the dye adsorption is increased. In another embodiment, when the diameter of the titanium dioxide nano particles is excessively small, it is difficult to disperse the nano particles within a paste, and efficiency is reduced due to electron recombination. In yet another embodiment, when the diameter of the titanium dioxide nano particles is excessively large, it is difficult to adsorb sufficient dye to improve efficiency of the solar cell.

In the dye-sensitized solar cell, the negative photoelectrode may include titanium dioxide nano particles, and a ratio of a diameter of the titanium dioxide nano wires included in the light scattering layer and a diameter of the titanium dioxide nano particles included in the negative photoelectrode may be from about 1:1 to about 10:1 1 (or from 1:1 to 10:1). In one embodiment, when the ratio is within the range described above, the efficiency of the solar cell is increased. On the other hand, in another embodiment, when the diameter of the titanium dioxide nano wires is excessively greater than that of the titanium dioxide nano particles, it is difficult to attach the nano particles to the nano wires. In yet another embodiment, when the diameter of the titanium dioxide nano wire is excessively smaller than that of titanium dioxide nano particles, scattering of solar light is reduced.

According to an embodiment of the present invention, a method of manufacturing a dye-sensitized solar cell includes preparing an oxide semiconductor layer and forming a light scattering layer on the oxide semiconductor layer. The forming of the light scattering layer includes preparing a precursor solution, electro-spinning the precursor solution onto the oxide semiconductor, and heat-treating the precursor solution. The precursor solution includes a titanium dioxide precursor, titanium dioxide nano particles, a binder, and solvent.

The light scattering layer may be formed, for example, by using the following method. First, a titanium dioxide precursor, titanium dioxide nano particles, a binder, and solvent are mixed to prepare a precursor solution. The titanium dioxide precursor may include at least one selected from the group consisting of titanium isopropoxide, titanium ethoxide, titanium chloride, and titanium methoxide, but is not limited thereto. In other embodiments, the titanium dioxide precursor may be any precursor that generates titanium dioxide by heat treatment.

The diameter of the titanium dioxide nano particles may be from about 10 nm to about 90 nm (or from 10 nm to 90 nm). In one embodiment, when the diameter is within the range described above, a surface area of the titanium dioxide nano particles is increased, and thus the dye adsorption is increased. In another embodiment, when the diameter of the titanium dioxide nano particles is excessively small, it is difficult to disperse the nano particles within the paste, and efficiency is reduced due to electron recombination. In yet another embodiment, when the diameter of the titanium dioxide nano particles is excessively great, it is difficult to adsorb sufficient dye to improve efficiency of the resulting solar cell.

The binder may be ethylcellulose, hydropropylcellulose, or the like, but is not limited thereto. In other embodiments, the binder may be any binder that is used in the art and is heat dissolved at a temperature of 400°C or more. Further, the solvent may be terpineol, ethanol, distilled water, ethylene glycol, $\alpha$-terpineol, or the like, but is not limited thereto. In other embodiments, the solvent may be any solvent that is used in the art.

An amount of the titanium dioxide nano particles may be from about 5 percent by weight (wt%) to about 20 wt% (or from 5 wt% to 20 wt%) based on the total weight of the precursor solution. In one embodiment, when the amount of the titanium dioxide nano particles is within the range described above, the IPCE of the solar cell is increased. On the other hand, in another embodiment, when the amount of the titanium dioxide nano particles is excessively high, nano rods are formed. In yet another embodiment, when the amount of the titanium dioxide nano particles is excessively low, dye adsorption area is reduced.

In the precursor solution, the amount of the titanium dioxide precursor in the precursor solution may be from about 10 parts by weight to about 150 parts by weight (or from 10 parts by weight to 150 parts by weight) based on 100 parts by weight of the titanium dioxide nano particles. In one embodiment, when the amount of the titanium dioxide precursor is within the range described above, the IPCE of the solar cell is increased. On the other hand, in another embodiment, when the amount of the titanium dioxide precursor is excessively high, an adhesive force is reduced. In yet another embodiment, when the amount of the titanium dioxide precursor is excessively low, it is difficult to form nano wires having a similar (for example, a uniform) diameter.

The amount of the binder in the precursor solution may be from about 20 parts by weight to about 40 parts by weight (or from 20 parts by weight to 40 parts by weight) based on 100 parts by weight of the titanium dioxide nano particles. In one embodiment, when the amount of the binder is within the range described above, the IPCE of the solar cell is increased. On the other hand, in another embodiment, when the amount of the binder is excessively high, the viscosity of the precursor solution is excessively high, and thus it is difficult to perform electro-spinning. In yet another embodiment, when the amount of the binder is excessively low, an adhesive force between nano wires and nano particles is reduced, and thus it is difficult to form the light scattering layer.

Next, the precursor solution is electro-spinned onto the oxide semiconductor, and then is heat-treated to thus form the light scattering layer. For example, the field-emitting_may be performed for from about 10 minutes to about 30 minutes (or from 10 minutes to 30 minutes) at a voltage ranging from about 5 kilovolts (kV) to about 10 kV (or from 5 kV to 10 kV) and at a rate ranging from about 10 microliters ($\mu\ell$) /minute to about 15 $\mu\ell$/minute (or from 10 $\mu\ell$/minute to

15 μℓ/minute). Under these conditions, the thickness of the light scattering layer may be adjusted according to a time taken to perform the electro-spinning.

The heat-treating may be performed at a temperature range from about 400°C to about 550°C (or from 400°C to 550°C). For example, the heat-treating may be performed at a temperature range from about 400°C to about 500°C (or from 400°C to 500°C). In one embodiment, when the temperature is within the range described above, the light scattering layer has few, if any, defects, and has high light transmittance. On the other hand, in another embodiment, when the temperature for the heat-treating is excessively high, glass is bent. In yet another embodiment, when the temperature for the heat-treating is excessively low, it is difficult to sinter titanium dioxide.

The oxide semiconductor layer may be prepared by using the following example method. First, titanium dioxide nano particles (oxide semiconductor particles) having a mean diameter ranging from about 10 nm to about 90 nm (or from 10 nm to 90 nm), acid, a binder, and a solvent are mixed to prepare a composition for the oxide semiconductor layer.

The composition is in a paste form with a viscosity ranging from about 10000 millipascal-seconds (mPa·s) to about 30000 mPa·s (or from 10000 mPa·s to 30000 mPa·s). The acid may be hydrochloric acid, nitric acid, acetic acid, or the like, and the amount of the acid may be in the range of from about 50 parts by weight to about 300 parts by weight (or from 50 parts by weight to 300 parts by weight) based on 100 parts by weight of the titanium dioxide nano particles. In one embodiment, when the amount of the acid is within the range described above, a negative photoelectrode manufactured from the oxide semiconductor layer formed using the acid has excellent photo current characteristics.

The binder may be ethylcellulose, hydraprapylceliulose, or the like, and the amount of the polymer for the binder may be in the range of from about 5 parts by weight to about 50 parts by weight (or from 5 parts by weight to 50 parts by weight) based on 100 parts by weight of the titanium dioxide nano particles. In one embodiment, when the amount of the solvent is within the range described above, a negative photoelectrode manufactured from the oxide semiconductor layer formed using the binder has excellent photo current characteristics.

The solvent may be terpineol, ethanol, distilled water, ethylene glycol, α-terpineol, or the like, and the amount of the solvent may be from about 200 parts by weight to about 900 parts by weight (or from 200 parts by weight to 900 parts by weight) based on 100 parts by weight of the titanium dioxide. In one embodiment, when the amount of the solvent is within the range described above, a negative photoelectrode manufactured from the oxide semiconductor layer formed using the solvent may have excellent photo current characteristics.

The composition for the oxide semiconductor layer is coated on a first electrode disposed on a first substrate and heat treated at a temperature ranging from about 400°C to about 550°C (or from 400°C to 550°C) to form an oxide semiconductor layer. The composition for the photoelectrode may be coated on the first electrode by spin coating, dip coating, casting, or the like, and the thickness of the oxide semiconductor layer may be from about 1000 nm to about 20000 nm (or from 1000 nm to 20000 nm). The coating and the heat-treating may be repeatedly performed several times.

Then, a photosensitive dye is concurrently (for example, simultaneously) adsorbed to the light scattering layer and the oxide semiconductor layer disposed below the light scattering layer to prepare a light scattering layer and a negative photoelectrode. The photosensitive dye may be a ruthenium-based dye, N3, N719, a black dye, or the like, but is not limited thereto. In other embodiments, the photosensitive dye may be any dye that is used in the art. In this regard, N3 is $RuL_2(NCS)_2$ (L=2,2'-bibyridyl-4,4'-dicarboxylic acid), N719 is $RuL_2(NCS)_2$: 2 TBA (L=2,2'-bipyridyl-4,4'-dicarboxylic acid, TBA=tetra-n-butylammonium).

The light scattering layer and the negative photoelectrode are dipped in a solution including a photosensitive dye having a concentration of from about 0.1 millimoles/liter (mM) to about 7 mM (or from 0.1 nM to 7 mM) to adsorb the photosensitive dye to the light scattering layer and the negative photoelectrode. The concentration of the dye may be in any suitable range in which the dye is adsorbed. In this regard, the solvent may be ethanol, isopropanol, acetonitrile, or valeronitrile, but is not limited thereto. In other embodiments, the solvent may be any solvent that is used in the art.

Then, a second electrode (located on a second substrate) is disposed to face the first electrode disposed on the light scattering layer and the negative photoelectrtode by adhering the second substrate to the first substrate. Finally, an electrolyte is injected between the first electrode and the second electrode to complete the manufacture of the dye-sensitized solar cell.

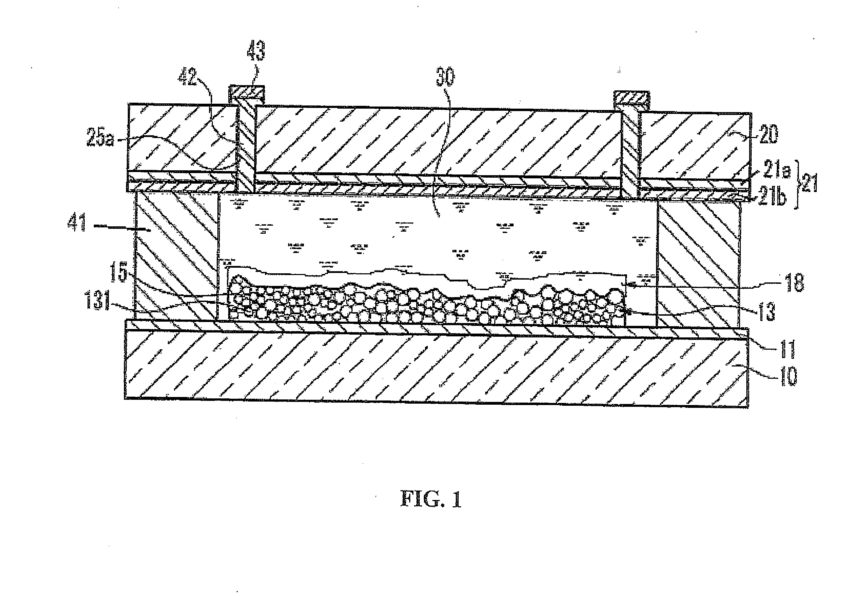

FIG. 1 is a cross-sectional view of a dye-sensitized solar cell according to an embodiment of the present invention.

Referring to FIG. 1, the dye-sensitized solar cell includes a first substrate 10 (on which a first electrode 11, a dye-sensitized negative photoelectrode 13 containing a dye 15, and the light scattering layer 18 also containing the dye are disposed), a second substrate 20 on which a second electrode 21 is disposed, and an electrolyte 30 disposed between the first electrode 11 and the second electrode 21. The first substrate 10 and the second substrate 20 face each other. A case may be disposed to envelop the first substrate 10 and the second substrate 20. The structure of the dye-sensitized solar cell will now be described in more detail.

The first substrate 10 (which supports the first electrode 11) is transparent and thus light can be transmitted therethrough. In this regard, the first substrate 10 may be formed of glass or plastic. Examples of the plastic include polyethylene terephthalate (PET), polyethylene naphthalate (PEN), polycarbonate (PC), polypropylene (PP), polyimide (PI), and triacetyl cellulose (TAC). The first substrate 10 may have visible ray transmittance of 91 % or more, and the amount of iron, which is calculated based on $Fe_2O_3$, may be 150 parts per million (ppm) or less. The thickness of the first substrate 10 may be from about 1 millimeter (mm) to about 5 mm (or from 1 mm to 5 mm).

The first electrode 11 disposed on the first substrate 10 may be formed of a transparent material selected from the group consisting of an indium tin oxide, an indium oxide, a tin oxide, a zinc oxide, a sulfur oxide, a fluorine oxide, a mixture thereof, $ZnO\text{-}Ga_2O_3$, and $ZnO\text{-}Al_2O_3$. The first electrode 11 may have a single or multi-layer structure including the transparent material.

The dye-sensitized negative photoelectrode 13 is disposed on the first electrode 11. The dye-sensitized negative photoelectrode 13 may include a plurality of titanium dioxide nano particles 131 having a mean diameter less than 100 nm. The dye-sensitized negative photoelectrode 13 may have a thickness of from about 5000 nm to about 20000 nm (or from 5000 nm to 20000 nm). However, the thickness of the dye-sensitized negative photoelectrode 13 is not limited thereto.

The light scattering layer 18 is disposed on the dye-sensitized negative photoelectrode 13. The light scattering layer 18 may include titanium dioxide nano particles having a mean diameter of from about 10 nm to about 90 nm (or from 10 nm to 90 nm), and titanium dioxide nano wires having a mean diameter of from about 10 nm to about 100 nm (or from 10 nm to 100 nm).

The dye 15, which absorbs light and generates exited electrons, is adsorbed to surfaces of the dye-sensitized negative photoelectrode 13 and the light scattering layer 18. Although not illustrated in FIG. 1, the dye 15 is also adsorbed to the light scattering layer 18.

The dye 15 may include at least one selected from the group selected from Aluminum (Al), platinum (Pt), palladium (Pd), europium (Eu), lead (Pb), iridium (Ir), and ruthenium (Ru). For example, the dye 15 may be a ruthenium dye, but is not limited thereto. In other embodiments, the dye may be any dye that is sensitive to solar light. For example, the dye 15 may be an organic dye that has an excellent molar extinction coefficient and high photoelectric conversion efficiency in a visible light wavelength range, is inexpensive, and can be used as a replacement for an expensive inorganic ruthenium dye.

The second substrate 20, which supports the second electrode 21 and is disposed to face the first substrate 10, may be transparent. The second substrate 20, like the first substrate 10, may also be formed of glass or plastic.

The second electrode 21 (disposed on the second substrate 20) is disposed to face the first electrode 11, and may include a transparent electrode 21 a and a catalyst electrode 21 b. For example, the transparent electrode 21 a may have a thickness of from about 100 nm to about 1000 nm (or from 100 nm to 1000 nm). For example, the catalyst electrode 21b may have a thickness of from about 1 nm to about 100 nm (or from 1 nm to 100 nm).

The transparent electrode 21a may be formed of a transparent material such as an indium tin oxide, a fluoro tin oxide, an antimony tin oxide, a zinc oxide, a tin oxide, $ZnO\text{-}Ga_2O_3$, $ZnO\text{-}Al_2O_3$, or the like. In this regard, the transparent electrode 21 a may have a single or multi-layer structure including the transparent material. The catalyst electrode 21 b activates a redox couple, and may be formed of platinum (Pt), ruthenium (Ru), palladium (Pd), iridium (Ir), rhodium (Rh), osmium (Os), carbon (C), $WO_3$, $TiO_2$ or the like.

The first substrate 10 is joined with the second substrate 20 using an adhesive (or support) 41. The electrolyte 30 is injected into the space between the first electrode 11 and the second electrode 21 through a hole 25a penetrating the second substrate 20 and the second electrode 21. The electrolyte 30 is uniformly dispersed in the dye-sensitized negative photoelectrode 13 and the light scattering layer 18. The electrolyte 30 transfers electrons from the second electrode 21 to the dye 15 through oxidation and reduction. The hole 25a penetrating the second substrate 20 and the second electrode 21 is sealed using an adhesive 42 and a cover glass 43.

Although not illustrated in FIG. 1, a porous metal oxide membrane may further be formed on the upper surface of the first electrode 11 and the lower surface of the dye-sensitized negative photoelectrode 13. The porous metal oxide membrane may be formed of metal oxide particles including a titanium oxide, a zinc oxide, a tin oxide, a strontium oxide, an indium oxide, an iridium oxide, a lanthanum oxide, a vanadium oxide, a molybdenum oxide, a tungsten oxide, a niobium oxide, a magnesium oxide, an aluminum oxide, an yttrium oxide, a scandium oxide, a samarium oxide, a gallium oxide, a strontium titanium oxide, or the like. In this regard, the metal oxide particles may be formed of $TiO_2$, $SnO_2$, $WO_3$, ZnO, or a complex thereof.

Hereinafter, one or more embodiments of the present invention will be described in detail with reference to the following examples. However, these examples are not intended to limit the purpose and scope of these or other embodiments of the present invention.

Examples 1 and 2 : Manufacture of a dye-sensitized solar cell

Example 1

An oxide semiconductor layer having a thickness of 10 $\mu$m was prepared by sequentially coating, drying, coating, and drying a titanium dioxide paste that is a composition for forming an oxide semiconductor layer on a conductive thin film including a first electrode formed of FTO (2.2T, T: glass thickness). The titanium dioxide paste that was the composition for forming an oxide semiconductor layer was PST 18NR (available from JGC C&C company PASTE).

A light scattering layer having a thickness of 2 $\mu$m was formed by electro-spinning a titanium dioxide precursor solution on the oxide semiconductor layer for 30 minutes at a voltage of 10 kV and a rate of 15 $\mu\ell$/minute, and then heat treating the titanium dioxide precursor solution for about 30 minutes at a temperature of 500°C. An inner diameter of a spraying nozzle was 1 mm, and a distance from the spraying nozzle to the oxide semiconductor layer was 30 cm.

The titanium dioxide precursor solution was prepared by mixing 12 wt% of titanium dioxide precursor, 3 wt% (30% of $TiO_2$) of ethylcellulose (binder), 10 wt% of titanium dioxide nano particle (DT51-D), and 75 wt% of solvent. A mean diameter of the titanium dioxide nano particles was 20 nm.

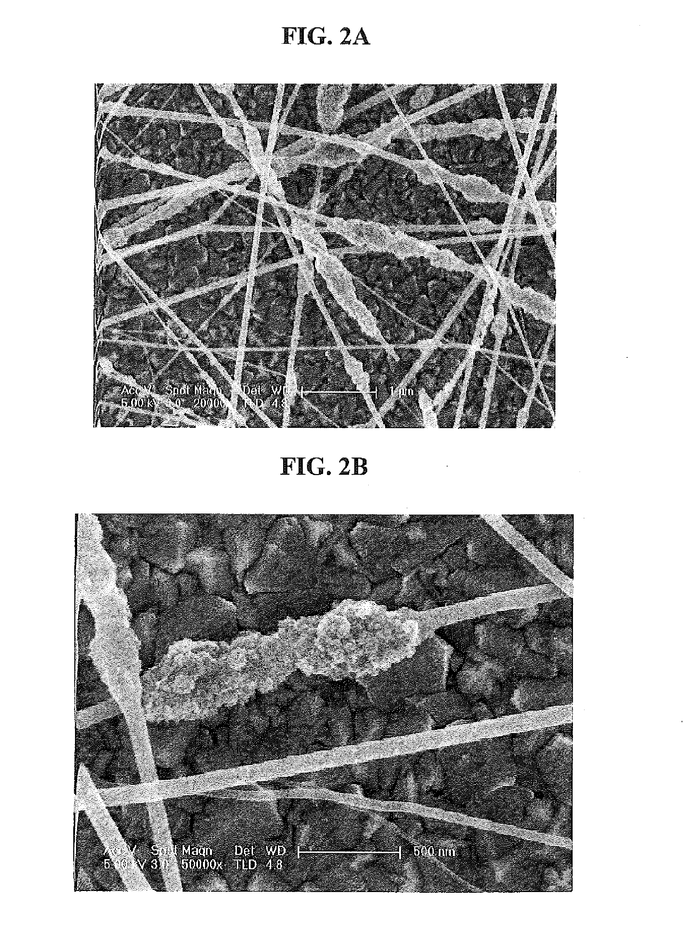

A mean diameter of titanium dioxide nano wires included in the light scattering layer was 50 nm. As shown in FIGS. 2A and 2B, a composite in which nano particles are attached onto surfaces of the nano wires was obtained. FIG. 2B is an enlarged image of FIG. 2A.

Then, the resultant was maintained at 80°C and immersed in a dye dispersion prepared by dispersing N719 as a dye in ethanol to a concentration of 0.3 mM for 12 hours or more for adsorbing the dye to the resultant. The oxide semiconductor layer and the light scattering layer to which the dye was adsorbed were washed with ethanol and dried at room temperature to thus prepare a first electrode on which a negative photoelectrode and a light scattering layer were sequentially stacked.

Separately, a second electrode was prepared by depositing a second conductive film formed of Pt on a first conductive film formed of an ITO using a sputter and forming a micropore for injecting an electrolyte by using a drill having a diameter of 0.75 mm. A support having a thickness of 60 $\mu$m and formed of a thermoplastic polymer film (Surlyn, DuPont, USA) was disposed between the first electrode and the second electrode, and the resultant was pressed at 100°C for 9 seconds to join the first and second substrates. An acetonitrile electrolyte including Lil (0.5M) and I (0.05M) was injected through the micropore formed in the second electrode, and then the micropore was sealed using a cover glass and a thermoplastic polymer film to thus complete the manufacture of the dye-sensitized solar cell.

Example 2

A dye-sensitized solar cell was manufactured in the same manner as in Example 1 except that the titanium dioxide precursor solution was electro-spinned for 15 minutes and the thickness of the light scattering layer was 1 $\mu$m.

Comparative Example 1: Solar cell without light scattering layer

An oxide semiconductor layer having a thickness of 10 $\mu$m was prepared by sequentially coating, drying, coating, and drying a titanium dioxide paste, which is a composition for forming an oxide semiconductor layer, on a conductive thin film including a first electrode formed of FTO (2.2T). The titanium dioxide paste that was the composition for forming an oxide semiconductor layer was PST 18NR (available from JGC C&C company PASTE).

Then, the resultant was maintained at 80°C and immersed in a dye dispersion prepared by dispersing N719 as a dye in ethanol to a concentration of 0.3 mM for 12 hours or more for adsorbing the dye to the resultant. The oxide semiconductor layer to which the dye was adsorbed was washed with ethanol and dried at room temperature to thus prepare a first electrode on which a negative photoelectrode was stacked.

Separately, a second electrode was prepared by depositing a second conductive film formed of Pt on a first conductive film formed of ITO by using a sputter, and forming a micropore for injecting an electrolyte by using a drill having a diameter of 0.75 mm. A support having a thickness of 60 $\mu$m and formed of a thermoplastic polymer film (Surlyn, DuPont, USA) was disposed between the first electrode and the second electrode, and the resultant was pressed at 100°C for 9 seconds to join the first and second substrates. An acetonitrile electrolyte including Lil (0.5M) and I (0.05M) was injected through the micropore formed in the second electrode, and then the micropore was sealed using a cover glass and a thermoplastic polymer film to thus complete the manufacture of the dye-sensitized solar cell. That is, the dye-sensitized solar cell of Comparative Example 1 includes only the negative photoelectrode.

Comparative Example 2: Solar cell including nano particle light scattering layer

An oxide semiconductor layer having a thickness of 10 $\mu$m was prepared by sequentially coating, drying, coating, and drying a titanium dioxide paste, which is a composition for forming an oxide semiconductor layer, on a conductive thin film including a first electrode formed of FTO (2.2T). The titanium dioxide paste that was the composition for forming an oxide semiconductor layer was PST 18NR (available from JGC C&C company PASTE).

A light scattering layer having a thickness of 4 $\mu$m was prepared by sequentially coating, drying, coating, and drying a titanium dioxide paste that was a composition for forming a light scattering layer on the oxide semiconductor layer and then heat treating the titanium dioxide paste for about 30 minutes at a temperature of 500°C. The titanium dioxide paste that was the composition for forming the light scattering layer was PST 400C(JGC C&C company PASTE) having a mean diameter of 400 nm.

Then, the resultant was maintained at 80°C and immersed in a dye dispersion prepared by dispersing N719 as a dye in ethanol to a concentration of 0.3 mM for 12 hours or more for adsorbing the dye to the resultant. The oxide semiconductor layer and the light scattering layer to which the dye was adsorbed were washed with ethanol and dried at room temperature to thus prepare a first electrode on which a negative photoelectrode and a light scattering layer were sequentially stacked.

Separately, a second electrode was prepared by depositing a second conductive film formed of Pt on a first conductive film formed of an ITO by using a sputter and forming a micropore for injecting an electrolyte by using a drill having a diameter of 0.75 mm. A support having a thickness of 60μm and formed of a thermoplastic polymer film (Surlyn, DuPont, USA) was disposed between the first electrode and the second electrode, and the resultant was pressed at 100°C for 9 seconds to join the first and second substrates. An acetonitrile electrolyte including LiI (0.5M) and I (0.05M) was injected through the micropore formed in the second electrode, and then the micropore was sealed using a cover glass and a thermoplastic polymer film to thus complete the manufacture of the dye-sensitized solar cell.

Evaluation Example 1: Evaluation of incident-photon-to-current efficiency (IPCE)

Photocurrent density of the dye-sensitized solar cells prepared according to Examples 1 and 2 as well as Comparative Examples 1 and 2 were measured, and an open circuit voltage, current density, and fill factor were calculated from the photocurrent curve. The results are shown in Table 1 below. Energy conversion efficiencies of the dye-sensitized solar cells were evaluated. In this regard, a xenon (Xe) lamp was used as the light source, and the sun condition of the xenon lamp was adjusted using a Fraunhofer Institute Solare Energiesysteme, Certificate No C-ISE369, Type of material, Mono-Si+KG filter. The photo current density was measured at a power density of 100 milliwatt per square centimeter (mW/cm$^2$).

The conditions for measuring the open circuit voltage, photocurrent density, energy conversion efficiency, fill factor, and the amount of dye adsorbed, as shown in Table 1 below, were as follows.

(1) Oven circuit voltage (V) and photocurrent density (in milliAmperes (mA)/cm$^2$):

Oven circuit voltage (V) and photocurrent density (mA/cm$^2$) were measured using a Keithley SMU2400.

(2) Energy conversion efficiency (%) and fill factor (%):

Energy conversion efficiency (%) was measured using 1.5 AM 100 mW/cm$^2$ solar simulator (Xe lamp [300W, Oriel], AM1.5 filter, and Keithley SMU2400), and the fill factor (%) was calculated using the energy conversion efficiency according to the following Equation 1.

[Equation 1]     $\text{Fill factor (FF) (\%)} = \{(J \times V)_{max} / (J_{sc} \times V_{oc})\} \times 100,$

where J is a value of the y axis, V is a value of the x axis, and Jsc and Voc are respectively the y-intercept and x-intercept of the I-V curve (energy conversion efficiency curve).

In addition, current-voltage characteristics of the dye-sensitized solar cells were analyzed using a Xe lamp (100 mW/cm$^2$) as a light source.

Table 1

| Solar Cell | Current density (Jsc) [mA/cm$^2$] | Oven circuit voltage (Voc) [V] | Fill factor (FF) [%] | Conversion efficiency η [%] |
|---|---|---|---|---|
| Example 1 | 11.08 | 0.75 | 74 | 6.1 |
| Example 2 | 10.12 | 0.75 | 75 | 5.6 |
| Comparative Example 1 | 8.46 | 0.76 | 76 | 4.9 |
| Comparative Example 2 | 9.98 | 0.75 | 74 | 5.5 |

Referring to Table 1, the dye-sensitized solar cell according to Examples 1 and 2 have a higher efficiency than those of Comparative Examples 1 and 2.

As described above, the dye-sensitized solar cell according to one or more of the above embodiments of the present invention has excellent efficiency due to reduced loss of solar light, excellent efficiency in terms of generating photoelectrons, and an increase in a path for transferring electrons.

It should be understood that the exemplary embodiments described herein should be considered in a descriptive sense only and not for purposes of limitation. Descriptions of features or aspects within each embodiment should typically be considered as available for other similar features or aspects in other embodiments.

While the present invention has been particularly shown and described with reference to embodiments thereof, it will be understood by those of ordinary skill in the art that various changes in form and details may be made therein without departing from the scope of the present invention as defined by the following claims, and equivalents thereof.

**Claims**

1.    A dye-sensitized solar cell comprising:

   a first electrode;
   a negative photoelectrode on the first electrode;
   a light scattering layer on the negative photoelectrode;
   a second electrode facing the first electrode with the negative photoelectrode and the light scattering layer therebetween; and
   an electrolyte between the first electrode and the second electrode,
   wherein the light scattering layer comprises a titanium dioxide nano wire and a titanium dioxide nano particle.

2.    A dye-sensitized solar cell according to claim 1, wherein the titanium dioxide nano particle is attached to at least one surface of the titanium dioxide nano wire to form a composite with the titanium dioxide nano wire.

3.    A dye-sensitized solar cell according to claim 1 or 2, wherein a thickness of the light scattering layer is from 1 $\mu$m to 5 $\mu$m.

4.    A dye-sensitized solar cell according to any preceding claim, wherein a mean diameter of the titanium dioxide nano wire is from 10 nm to 100 nm.

5.    A dye-sensitized solar cell according to any preceding claim, wherein a mean diameter of the titanium dioxide nano particle is from 10 nm to 90 nm.

6.    A dye-sensitized solar cell according to any preceding claim,
   wherein the negative photoelectrode comprises a titanium dioxide nano particle,
   and
   wherein a ratio of a diameter of the titanium dioxide nano wire and a diameter of the titanium dioxide nano particle included in the negative photoelectrode is from 1:1 to 10:1.

7.    A method of manufacturing a dye-sensitized solar cell, the method comprising:

   preparing an oxide semiconductor layer; and
   forming a light scattering layer on the oxide semiconductor layer, the forming of the light scattering layer comprising:

      preparing a precursor solution comprising a titanium dioxide precursor, titanium dioxide nano particles, a binder, and solvent;
      electro-spinning the precursor solution onto the oxide semiconductor; and
      heat-treating the precursor solution.

8.    A method according to claim 7, wherein the titanium dioxide precursor comprises titanium isopropoxide, titanium ethoxide, titanium chloride, or titanium methoxide.

9.    A method according to claim 7 or 8, wherein a mean diameter of the titanium dioxide nano particles is from 10 nm to 90 nm.

10. A method according to claim 7, 8 or 9 wherein an amount of the titanium dioxide nano particles is from 5 wt% to 20 wt% based on a total weight of the precursor solution.

11. A method according to one of claims 7 to 10, wherein an amount of the titanium dioxide precursor in the precursor solution is from 10 parts by weight to 150 parts by weight based on 100 parts by weight of the titanium dioxide nano particles.

12. A method according to one of claims 7 to 11, wherein an amount of the binder in the precursor solution is from 20 parts by weight to40 parts by weight based on 100 parts by weight of the titanium dioxide nano particles.

13. A method according to one of claims 7 to 12, wherein the electro-spinning is performed for from 10 minutes to 30 minutes at a voltage in a range from 5 kV to 10 kV and at a rate in a range from10 $\mu\ell$/minute to 15 $\mu\ell$/minute.

14. A method according to one of claims 7 to 13, wherein the heat-treating is performed at a temperature in a range from 400°C to550°C.

FIG. 1

## FIG. 2A

## FIG. 2B